# EUROPÄISCHE PATENTSCHRIFT

(11) **EP 3 192 130 B1**
(45) Veröffentlichungstag und Bekanntmachung des Hinweises auf die Patenterteilung: **22.08.2018**
(21) Anmeldenummer: 15730766.1
(22) Anmeldetag: 19.06.2015
(51) Int. Cl.: H01R 12/58, H01R 43/20, H05K 13/04, B23P 19/033

(54) **VERFAHREN ZUR LÖTFREIEN ELEKTRISCHEN EINPRESSKONTAKTIERUNG VON ELEKTRISCH LEITFÄHIGEN EINPRESS-STIFTEN IN LEITERPLATTEN**
METHOD FOR SOLDERLESS ELECTRICAL PRESS-IN CONTACTING OF ELECTRICALLY CONDUCTIVE PRESS-IN PINS IN CIRCUIT BOARDS
PROCÉDÉ DE MISE EN CONTACT ÉLECTRIQUE PAR INSERTION SANS SOUDURE DE BROCHES ÉLECTRIQUEMENT CONDUCTRICES À INSÉRER DANS DES CARTES DE CIRCUITS IMPRIMÉS

(30) Priorität: 08.09.2014 DE 102014217927
(43) Veröffentlichungstag der Anmeldung: 19.07.2017
(73) Patentinhaber: Robert Bosch GmbH, 70442 Stuttgart (DE)
(72) Erfinder: OTTO, Andreas, 99819 Hoerselberg-Hainich (DE); HALM, Cynthia, 99817 Eisenach (DE)
(86) Internationale Anmeldenummer: PCT/EP2015/063799
(87) Internationale Veröffentlichungsnummer: WO 2016/037716

(56) Entgegenhaltungen:
- DE-A1- 4 242 837
- DE-A1- 10 052 613
- DE-A1- 10 222 200

## Beschreibung

### Gebiet der Erfindung

Die Erfindung betrifft ein Verfahren zur lötfreien elektrischen Einpresskontaktierung von elektrisch leitfähigen Einpress-Stiften in Leiterplatten mit den Merkmalen des Oberbegriffs des unabhängigen Anspruchs.

### Stand der Technik

Unter dem Begriff "kalte Kontaktiertechnik" ist die Gruppe der nichtlösbaren kraftschlüssigen und formschlüssigen elektrischen Kontakte zusammengefasst. Gemeinsames Merkmal aller Varianten ist, dass der elektrische Kontakt allein durch Verpressen oder Verklemmen der Fügepartner hergestellt wird.

Einpress-Verbindungen zur direkten Kontaktierung von Leiterplatten kommen in zahlreichen Produkten zum Einsatz. Die Varianten-Vielfalt reicht von Einzel-Einpress-Stiften (Pins) in Bordcomputern bis hin zu Steckerleisten mit bis zu mehreren hundert Einpress-Stiften in Steuergeräten. Bei großer Anzahl einzupressender Einpress-Stifte steigt die Anforderung an die Genauigkeit der Abstände und der Orientierung der Einpress-Stifte untereinander, der Kontaktierungsöffnungen in der Leiterplatte sowie der Positionierung der Einpress-Stifte vor und während des Pressvorgangs bezüglich der Kontaktierungsöffnungen.

Üblicherweise werden die Einzel-Einpress-Stifte (Pins) in einen Schaltungsträger eingepresst. Dabei sind große Kräfte (abhängig von der Anzahl der Pins ca. 100-300 Newton pro Pin), große Genauigkeitsanforderungen sowie Tabuzonen zur Minimierung von Beschädigungen benachbarter Strukturen notwendig. Eine Ultraschall-Unterstützung beim Einpressen der Pins in die Leiterplatte führt zu einer Verbesserung der oben genannten Punkte.

Aus der DE 42 42 837 A1 ist ein Verfahren zum Einpressen von metallischen Elementen in Leiterplatten bekannt.

Aus der DE 42 42 837 A1 sind ein Verfahren und eine Vorrichtung zum Einpressen von metallischen Elementen in Trägerteile bekannt.

Aus der DE 102 22 200 A1 ist ein elektrisches Gerät mit zwei Gehäuseteilen bekannt, die durch ein Einpress-Bauelement verbunden sind.

Aus der DE 100 52 613 A1 sind eine Vorrichtung und ein Verfahren zum Einpressen eines Stiftes in eine Öffnung eines Körpers bekannt.

### Offenbarung der Erfindung

Die Erfindung geht aus von der Erkenntnis, dass beim Einpressen massiver Einpress-Stifte die Kontaktierungsöffnung in der Leiterplatte relativ einfach beschädigt werden kann. Weiterhin sind bei der Verwendung massiver Einpress-Stifte sehr enge Fertigungstoleranzen notwendig. Bei flexiblen Einpress-Stiften, die sich quer zur Einpressrichtung elastisch reversibel zusammendrücken lassen, schränkt die Federgeometrie der Einpress-Stifte die Werkstoffauswahl ein.

Durch den Einsatz von Ultraschall beim Einpressvorgang kann das Risiko einer Beschädigung der Kontaktierungsöffnung deutlich reduziert werden. Jedoch ist bei herkömmlichen Verfahren das Einpressen der Einpress-Stifte in die Leiterplatte sehr zeitaufwändig, da das Einpressen für jeden Stift hintereinander, also sequenziell, erfolgt. Weiterhin ist das Einpressen von Bauelementen, welche eine Mehrzahl von Kontaktstiften aufweist (z.B. integrierte Schaltkreise, Sensoren in zum Beispiel SOIC-Gehäuse, etc.) mit der Ultraschall-Einpress Technik nicht bzw. nicht ohne Weiteres möglich.

Es kann daher ein Bedarf bestehen, ein Verfahren bereitzustellen, welches es ermöglicht eine Vielzahl von Pins bzw. Einpress-Stiften mittels kalter Kontaktiertechnik gleichzeitig in eine Leiterplatte mit Ultraschall-Unterstützung einzupressen. Insbesondere kann ein Bedarf bestehen, eine bereits annähernd fertig bestückte Leiterplatte in einem möglichst kurzen Zeitintervall mit einem oder mehreren Bauelementen, die jeweils mindestens einen Einpress-Stift aufweisen bzw. eine Mehrzahl von Einpress-Stiften aufweisen, mit Hilfe von ultraschallunterstützter kalter Kontaktiertechnik zu bestücken.

### Vorteile der Erfindung

Dieser Bedarf kann durch den Gegenstand der vorliegenden Erfindung gemäß des unabhängigen Anspruchs gedeckt werden. Vorteilhafte Ausführungsformen der vorliegenden Erfindung sind in den abhängigen Ansprüchen beschrieben.

Im Folgenden werden Merkmale, Einzelheiten und mögliche Vorteile eines Verfahrens zur lötfreien elektrischen Einpresskontaktierung von elektrisch leitfähigen Einpress-Stiften in Leiterplatten gemäß Ausführungsformen der Erfindung im Detail diskutiert.

Gemäß einem ersten Aspekt der Erfindung wird ein Verfahren zur lötfreien elektrischen Einpresskontaktierung von elektrisch leitfähigen Einpress-Stiften in Leiterplatten vorgeschlagen. Dieses ermöglicht es, die Leiterplatte gleichzeitig mit einem oder mehreren Einpress-Bauelementen zu bestücken. Dabei weisen das oder die Einpress-Bauelemente jeweils wenigstens einen Einpress-Stift, bevorzugt eine Mehrzahl von Einpress-Stiften, auf.

Dies wird dadurch erreicht, dass das Verfahren folgende Schritte aufweist: Bereitstellen einer Leiterplatte mit wenigstens einer im wesentlichen senkrecht durch die Leiterplatte hindurchgeführte Kontaktierungsöffnung zur Einpresskontaktierung. Bereitstellen wenigstens eines Einpress-Bauelements mit wenigstens einem elektrisch leitfähigen Einpress-Stift. Bereitstellen einer Sonotrode zur Ausübung einer Kraft und zur Aufbringung von Ultraschallenergie. Dabei ist vorgesehen, dass das wenigstens eine Einpress-Bauelement mit seinem wenigstens einen Einpress-Stift während eines Einpress-Schritts fixiert ist, insbesondere ortsfest gehalten ist, und dass in dem Einpress-Schritt die Leiterplatte mittels der Sonotrode derart mit einer Kraft (F) und mit Ultraschallenergie (I) direkt beaufschlagt wird, dass die Leiterplatte an der Stelle ihrer wenigstens einen Kontaktierungsöffnung auf den wenigstens einen nicht direkt mittels der Sonotrode beaufschlagten Einpress-Stift des wenigstens einen Einpress-Bauelements aufgepresst wird.

Gegenüber dem Stand der Technik weist das erfindungsgemäße Verfahren den Vorteil auf, gleichzeitig und damit besonders zeitsparend eine große Anzahl von Einpress-Bauelementen bzw. eine große Anzahl von Einpress-Stiften in die Leiterplatte einpressen zu können. Durch die Verwendung der ultraschallunterstützten kalten Kontaktiertechnik kann gegenüber herkömmlichen Verfahren eine hochfeste Verbindung mittels kalter Verschweißung, also eine stoffschlüssige Verbindung, bewirkt werden. Dabei werden die Kontaktpartner (Leiterplatte und Einpress-Bauelement) vorteilhaft keiner bzw. nur einer geringen bzw. nur einer an der Kontaktstelle zwischen Einpress-Stift und Kontaktierungsöffnung lokalisierten thermischen Belastung (durch den Reibprozess des Ultraschalls) ausgesetzt.

Darüber hinaus ist es mit dem vorgeschlagenen Verfahren möglich, die ultraschallunterstützte kalte Kontaktiertechnik auch für Einpress-Stifte zu verwenden, die in einem Träger fest angeordnet sind, wobei der Träger beispielsweise ein Steckverbinder ist, auf welchen die Leiterplatte zur Kontaktierung aufgepresst wird. Ein derartiger Träger mit seinem wenigstens einen Einpress-Stift kann im Sinne der Anmeldung als Einpress-Bauelement verstanden werden. Vorteilhaft kann durch das vorgeschlagene Verfahren gegenüber dem Stand der Technik eine Reduzierung von konstruktiven Toleranzketten bewirkt werden (z.B. zur Bestimmung von Mindestabständen zwischen Bauelementen), wodurch eine engere Bestückung der Leiterplatte mit Einpress-Bauelementen möglich wird. Ebenso vorteilhaft können die Fertigungstoleranzen für die Herstellung der Einpress-Stifte erhöht werden, wodurch eine geringere Ausschussquote erzielbar ist und die Kosten deutlich reduziert werden können.

Vorteilhaft sind mit dem vorgeschlagenen Verfahren auch komplexe Werkzeuge zur Ultraschallkopplung verzichtbar. Denn die Sonotrode greift direkt an der Leiterplatte an. Schließlich ist das vorgeschlagene Verfahren im Wesentlichen unabhängig von der Anzahl der in die Leiterplatte einzupressenden Einpress-Stifte.

Vorteilhaft kann mit dem vorgeschlagenen Verfahren auch auf federnde Einpress-Stifte verzichtet werden, wodurch eine wesentlich größere Materialauswahl für das Material des wenigstens einen Einpress-Stifts zur Verfügung steht. Es sei angemerkt, dass das Verfahren selbstverständlich auch mit federnden Einpress-Stiften funktioniert.

Diese Vorteile werden dadurch bewirkt, dass das wenigstens eine Einpress-Bauelement während des Einpress-Schritts fixiert, insbesondere also ortsfest gehalten wird und keiner direkten Beaufschlagung mit Ultraschall ausgesetzt wird. Insbesondere greift die Sonotrode nicht an dem wenigstens einen Einpress-Bauelement an. Durch das Aufsetzen der Leiterplatte auf den wenigstens einen Einpress-Stift des wenigstens einen Einpress-Bauelements und das direkte Beaufschlagen der Leiterplatte mit einer Kraft (der Einpresskraft) und mit Ultraschallenergie durch die Sonotrode muss lediglich ein Fügepartner, nämlich die Leiterplatte, mit der Sonotrode in Kontakt gebracht werden. Das Einpressen sämtlicher mit der Leiterplatte in Kontakt gebrachter Einpress-Stifte in einem einzigen Vorgang kann dadurch auf einfache Art und Weise bewirkt werden. Die Sonotrode kann während des Kraft- und Ultraschall-Beaufschlagungs-Prozesses mit der Leiterplatte (temporär) fest verbunden sein, z.B. durch Vakuum, eine temporäre Verschraubung oder durch magnetische Halterungen.

Mit anderen Worten wird im Gegensatz zu herkömmlichen Verfahren nicht jeder einzelne Stift mit Ultraschallunterstützung in die Leiterplatte eingepresst. Vielmehr wird die Leiterplatte mittels der Sonotrode mit Ultraschallenergie und Kraft beaufschlagt und derart auf den wenigstens einen gehalterten Einpress-Stift in einem einzigen Schritt aufgepresst. Auf diese Weise können vorteilhaft auch Einpress-Bauelemente wie zum Beispiel integrierte Schaltkreise oder Sensoren in Form beispielsweise von SOIC-Gehäusen mit der Leiterplatte verpresst werden. Allgemein können dadurch Bauelemente mit Einpress-Stiften, die bereits in einem Gehäuse z.B. mit Kunststoff umspritzt sind, mit der Leiterplatte verpresst werden. Auch wird das Aufpressen der Leiterplatte auf Steckverbinder mit massiven Pins möglich, wobei in diesem Fall die Pins bereits vor dem Einpress-Vorgang in einem Gehäuse des Steckverbinders befestigt sind, z.B. mit Kunststoff umspritzt sind.

Es kann bei diesem Verfahren vorkommen, dass auch der wenigstens eine Einpress-Stift eine Ultraschall-Anregung erfährt. Diese Ultraschall-Anregung ist dabei jedoch lediglich durch den Kontakt des Einpress-Stifts mit der ultraschallbeaufschlagten Leiterplatte gegeben. Der Einpress-Stift schwingt in einem derartigen Szenario somit lediglich passiv mit. Eine direkte Anregung des Einpress-Stifts mit Ultraschallenergie über eine Sonotrode ist nicht vorgesehen.

Bei der Leiterplatte kann es sich um eine starre Leiterplatte aus einem Material FR4 oder besser handeln. Die Leiterplatte kann auch eine keramische Leiterplatte sein. Die Leiterplatte kann auf ihrer Oberfläche oder in Ihrem Innern wenigstens eine elektrisch leitfähige Leiterbahn aufweisen. Die Kontaktierungsöffnung der Leiterplatte kann als eine elektrisch leitfähige Hülse ausgebildet sein, beispielsweise eine in die Leiterplatte eingepresste Hülse. Die Kontaktierungsöffnung kann auch als eine durch die Leiterplatte hindurchgeführte Bohrung ausgebildet sein, welche beispielsweise an ihrer Innenwand eine elektrisch leitfähige Beschichtung, beispielsweise eine Metallbeschichtung aufweist. Die Kontaktierungsöffnung kann somit an ihrer Innenwandung beispielsweise vollständig metallisiert sein. Die Kontaktierungsöffnung kann einen im Wesentlichen runden Querschnitt aufweisen. Jedoch sind auch andere Querschnitte, z.B. ovale, rechteckige oder langlochartige Querschnitte möglich

Die Sonotrode kann Ultraschall mit Frequenzen bis zu 70 kHz oder auch bis zu 140 kHz auf die Leiterplatte aufbringen. Die Amplitude der Ultraschall-Schwingung kann im Mikrometer-Bereich liegen. Beispielsweise kann die Amplitude der Ultraschall-Schwingung bis zu 10µm oder bis zu 20µm, bevorzugt bis zu 50µm und ganz besonders bevorzugt bis zu 100µm betragen. Bei den Ultraschall-Schwingungen kann es sich bezüglich des Einpress-Stiftes um longitudinale und/oder transversale Ultraschall-Schwingungen handeln. Die Ultraschallenergie ist unter anderem abhängig von der Frequenz und von der Amplitude der Ultraschall-Schwingung.

Der wenigstens eine Einpress-Stift kann quer zu seiner Längsachse beispielsweise einen quadratischen oder rechteckigen oder dreieckigen oder runden oder ovalen Querschnitt aufweisen.

Gemäß einer Ausführungsform der Erfindung ist vorgesehen, dass die Leiterplatte vor dem Einpress-Stift bereits mit Bauelementen bestückt ist, insbesondere, dass das Bestücken der Leiterplatte mit Bauelementen bis auf den Einpress-Stift für das Bestücken mit dem wenigstens einen Einpress-Bauelement vollständig beendet ist. Dadurch wird vorteilhaft bewirkt, dass die vollständig bestückte Leiterplatte beispielsweise auf Einpress-Stifte eines Steckverbinders aufgepresst werden kann, wodurch dann beispielsweise ohne thermische Belastung ein Steuergerät fertig montiert sein kann. Weiterhin wird dadurch vorteilhaft bewirkt, dass beispielsweise gegenüber thermischen Belastungen unempfindliche Bauelemente mittels eines Lötprozesses oder eines Bondprozesses zunächst auf der Leiterplatte befestigt werden können und dass anschließend temperaturempfindliche Bauelemente in einem einzigen Schritt und somit sehr Zeit sparend mittels der ultraschallunterstützten Einpresstechnik mit der Leiterplatte elektrisch und mechanisch verbunden werden können. Dadurch lassen sich die Vorteile der jeweiligen Verfahren nutzen, ohne dass das Einpress-Verfahren übermäßig zeitintensiv ist.

Gemäß einer Ausführungsform der Erfindung ist vorgesehen, dass die Sonotrode auf einer der Leiterplatte zugewandten Seite an denjenigen Stellen Aussparungen aufweist, die beim Einpress-Schritt den mit Bauelementen bestückten Stellen der der Sonotrode zugewandten Seite der Leiterplatte gegenüberliegen. Dadurch wird vorteilhaft bewirkt, dass die bereits auf der Leiterplatte befindlichen Bauelemente nicht durch die Sonotrode beschädigt werden. Besonders vorteilhaft wird dadurch bewirkt, dass die Sonotrode unmittelbar auf einer Oberfläche der Leiterplatte zur Anlage kommen kann, da die bestückten Stellen der Leiterplatte in der Sonotrode ausgespart sind. Dadurch wird eine besonders effiziente Einkopplung der Ultraschallenergie in die Leiterplatte bewirkt.

Gemäß einer Ausführungsform der Erfindung ist vorgesehen, dass die Leiterplatte eine dem wenigstens einen Einpress-Bauelement zugewandte erste Seite und eine von der ersten Seite abgewandte zweite Seite aufweist. Dabei wird die Sonotrode beim Einpress-Schritt auf der zweiten Seite aufgesetzt. Dabei kann die Sonotrode wenigstens 50% der Fläche der zweiten Seite überdecken, besonders bevorzugt überdeckt die Sonotrode wenigstens 75% der Fläche der zweiten Seite und ganz besonders bevorzugt wenigstens 90% der Fläche der zweiten Seite. Dadurch wird vorteilhaft bewirkt, dass die Kraft für den Einpress-Schritt und die Ultraschallenergie für den Einpress-Schritt möglichst flächig und gleichmäßig auf die Leiterplatte aufgebracht bzw. in die Leiterplatte eingekoppelt wird. Dies bewirkt eine besonders geringe Belastung der Leiterplatte bzw. bereits auf der Leiterplatte befestigter Bauelemente beim Einpress-Schritt (zum Beispiel kann eine Verbiegung der Leiterplatte dadurch gering gehalten werden oder auch eine hohe punktuelle Ultraschallbelastung vermieden werden). Vorteilhaft wird dadurch eine besonders homogene Verbindung zwischen dem wenigstens einen Einpress-Stift und der Leiterplatte bewirkt.

Gemäß einer Ausführungsform der Erfindung ist vorgesehen, dass die Sonotrode die Leiterplatte während des Einpress-Schritts entlang der Erstreckungsrichtung der wenigstens einen Kontaktierungsöffnung über eine Wegstrecke S auf den wenigstens einen Einpress-Stift aufpresst. Dabei wird die Sonotrode während des Einpressvorgangs entlang der Wegstrecke S mit einer ersten Kraft (F1) und mit einer ersten Ultraschallenergie (I1) beaufschlagt. Dadurch wird vorteilhaft bewirkt, dass die Einpresstiefe besonders genau einstellbar ist. Die Einpresstiefe wird durch die Wegstrecke S dargestellt. Dabei bemisst sich die Wegstrecke S ab einem ersten Berührpunkt zwischen der Leiterplatte und dem wenigstens einen Einpress-Stift.

Gemäß einer Ausführungsform der Erfindung ist vorgesehen, dass nach Erreichen der Wegstrecke S die Sonotrode eine zweite Kraft (F2) auf die Leiterplatte ausübt, wobei die zweite Kraft (F2) sehr gering gegenüber der ersten Kraft (F1) ist, insbesondere dass die zweite Kraft (F2) höchstens 10 % der ersten Kraft (F1) beträgt. Weiterhin beaufschlagt die Sonotrode nach Erreichen der Wegstrecke S eine zweite Ultraschallenergie (I2) auf die Leiterplatte, wobei die zweite Ultraschallenergie (I2) größer ist als die erste Ultraschallenergie (I1), insbesondere um wenigstens 25 % größer ist als die erste Ultraschallenergie (I1). Dabei kann die zweite Kraft (F2) annähernd Null betragen. Dabei kann die erste Ultraschallenergie (I1) Null oder annähernd Null betragen. Dadurch wird vorteilhaft bewirkt, dass in dem eigentlichen Aufpressvorgang, der sich entlang der Wegstrecke S erstreckt, das Aufpressen im Wesentlichen durch die Beaufschlagung mit der ersten Kraft (F1) erfolgt. In diesem Teil des Einpress-Schritts kann die Ultraschallenergie, also die erste Ultraschallenergie (I1), z.B. vor allem dazu dienen, den Aufpressvorgang zu erleichtern bzw. zu beschleunigen. Dies wird bewirkt, indem die Ultraschall Beaufschlagung einen Gleitprozess beim Aufpressen erzeugt bzw. erleichtert (die Ultraschallenergie verhindert ein Verhaken bzw. Verkanten des Einpress-Stiftes in der Kontaktierungsöffnung). Nach Erreichen der Wegstrecke S kann durch eine Erhöhung der Ultraschallenergie, insbesondere durch eine deutliche Erhöhung der Ultraschallenergie, auf die zweite Ultraschallenergie (I2) eine Reibverschweißung zwischen dem wenigstens einen Einpress-Stift und der Leiterplatte bewirkt werden. Dadurch wird eine stoffschlüssige Verbindung zwischen dem wenigstens einen Einpress-Stift und der Leiterplatte ermöglicht. Eine derartige stoffschlüssige Verbindung (z.B. eine Reibschweißverbindung) weist eine erhöhte Haltekraft gegenüber einer rein formschlüssigen bzw. kraftschlüssigen Verbindung auf und kann daher stabiler sein, als eine Verbindung, die sich aus einem reinen Aufpressvorgang ergibt.

Alternativ kann die zweite Ultraschallenergie (I2) kleiner sein als die erste Ultraschallenergie (I1), insbesondere um wenigstens 25% kleiner als die erste Ultraschallenergie (I1). Weiterhin kann in einer weiteren Alternative die zweite Ultraschallenergie (I2) gleich der ersten Ultraschallenergie (I1) sein.

Dadurch, dass der wenigstens eine Einpress-Stift aus einem Material besteht, das Metall oder eine Metall-Legierung aus der Gruppe Aluminium oder Kupfer oder Eisen umfasst, wird vorteilhaft bewirkt, dass besonders kostengünstige Materialien verwendbar sind. Vorteilhaft kann durch die Verwendung derartiger Materialien besonders einfach eine stoffschlüssige Verbindung durch die Ultraschall-Beaufschlagung zwischen dem wenigstens einen Einpress-Stift und der Leiterplatte bzw. der Innenwandung der Kontaktierungsöffnung der Leiterplatte bewirkt werden. Besonders vorteilhaft lässt sich mit derartigen Materialien eine besonders stabile stoffschlüssige Verbindung zwischen dem wenigstens einen Einpress-Stift und der Leiterplatte bewirken, wodurch die Haltekräfte des wenigstens einen Einpress-Stifts in der Leiterplatte gegenüber herkömmlichen Einpress-Stiften besonders stark erhöht sind. Dies kann vorteilhaft zu einer besonders hohen mechanischen Belastbarkeit der Leiterplatten-Einpress-Bauelement-Verbindung führen.

Dadurch, dass der wenigstens eine Einpress-Stift massiv ausgebildet ist, insbesondere ohne einen Hohlraum und ohne federnde Abschnitte, wird vorteilhaft bewirkt, dass der wenigstens eine Einpress-Stift und damit das den wenigstens einen Einpress-Stift aufweisende Einpress-Bauelement besonders kostengünstig hergestellt werden können. Besonders vorteilhaft können dadurch auch Materialien für die Herstellung des wenigstens einen Einpress-Stiftes verwendet werden, die keine besonders guten Federeigenschaften aufweisen. Besonders vorteilhaft können Kupfer-Eisen-Legierungen verwendet werden. Insgesamt erhöht sich dadurch vorteilhaft die Design-Freiheit bei der Auswahl bzw. der Herstellung der Einpress-Stifte.

Gemäß einer Ausführungsform der Erfindung ist vorgesehen, dass an dem wenigstens einen Bauelement eine Mehrzahl von Einpress-Stiften, insbesondere wenigstens zwei Einpress-Stifte, bevorzugt wenigstens vier Einpress-Stifte, vorgesehen sind. Dabei wird eine Leiterplatte bereitgestellt, die eine Anzahl von Kontaktierungsöffnungen aufweist, die wenigstens der Anzahl der Einpress-Stifte des wenigstens einen Bauelements entspricht. Mit anderen Worten ist für jeden Einpress-Stift wenigstens eine Kontaktierungsöffnung in der Leiterplatte vorgesehen. Dadurch wird vorteilhaft bewirkt, dass in einem einzigen Schritt besonders zeitsparend das Einpress-Bauelement bzw. die Vielzahl von Einpress-Stiften mit der Leiterplatte elektrisch und mechanisch verbunden werden können.

### Zeichnungen

Weitere Merkmale und Vorteile der vorliegenden Erfindung werden dem Fachmann aus der nachfolgenden Beschreibung beispielhafter Ausführungsformen, die jedoch nicht als die Erfindung beschränkend auszulegen sind, unter Bezugnahme auf die beigelegten Zeichnungen ersichtlich.

Es zeigen:
Fig. 1a einen Querschnitt durch eine erste Ausführungsform einer Anordnung zur Durchführung des erfindungsgemäßen Verfahrens vor dem Einpress-Schritt;
Fig. 1b die Anordnung aus Fig. 1a nach dem Einpress-Schritt;
Fig. 2a einen Querschnitt durch eine zweite Ausführungsform einer Anordnung zur Durchführung des erfindungsgemäßen Verfahrens vor dem Einpress-Schritt;
Fig. 2b die Anordnung aus Fig. 2a nach dem Einpress-Schritt;
Fig. 3 eine Ausführungsform des erfindungsgemäßen Verfahrens.

Alle Figuren sind lediglich schematische Darstellungen des erfindungsgemäßen Verfahrens bzw. von Schritten des Verfahrens bzw. von Anordnungen in verschiedenen Schritten des Verfahrens gemäß Ausführungsbeispielen der Erfindung. Insbesondere Abstände und Größenrelationen sind in den Figuren nicht maßstabsgetreu wiedergegeben. In den verschiedenen Figuren sind sich entsprechende Elemente mit den gleichen Referenznummern versehen.

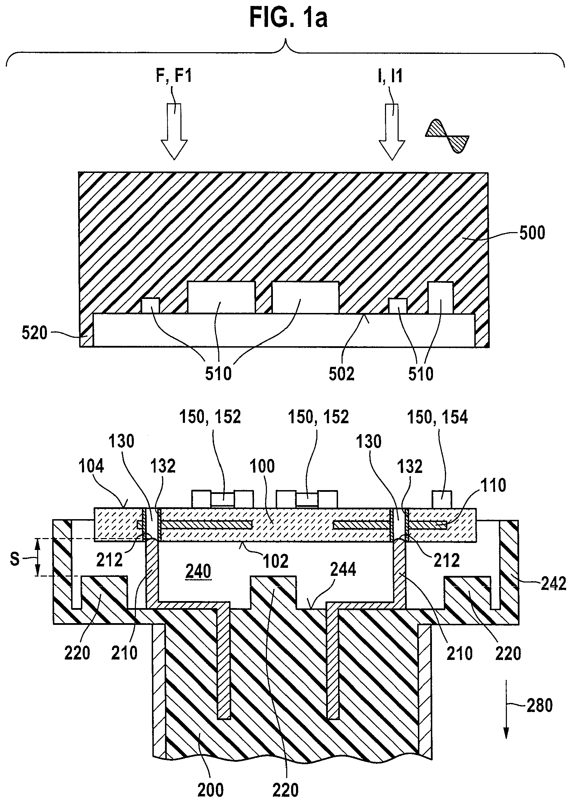

In Fig. 1a ist eine Anordnung zur Ausführung des erfindungsgemäßen Verfahrens dargestellt. Die Anordnung in Fig. 1a stellt das Verfahren im Schritt vor dem Einpress-Schritt dar. Zur Durchführung des Verfahrens zur lötfreien elektrischen Einpresskontaktierung von elektrisch leitfähigen Einpress-Stiften 210 in Leiterplatten 100 wird hierzu eine Leiterplatte 100, eine Sonotrode 500 zur Ausübung einer Kraft und zur Aufbringung von Ultraschallenergie sowie ein Einpress-Bauelement 200 mit in diesem Querschnitt zwei sichtbaren Einpress-Stiften 210 bereitgestellt.

Die Leiterplatte 100 ist hierbei zwischen dem Einpress-Bauelement 200 und der Sonotrode 500 angeordnet.

Die Leiterplatte 100 kann aus FR4-Material oder besser oder als Keramik-Leiterplatte ausgebildet sein. Die Leiterplatte weist eine erste Seite 102 auf, die dem Einpress-Bauelement 200 zugewandt ist. Die Leiterplatte 100 weist außerdem eine zweite Seite 104 auf, die von der ersten Seite 102 abgewandt ist. Die zweite Seite 104 ist der Sonotrode 500 zugewandt.

Die Leiterplatte 100 weist wenigstens eine Leiterbahn 110 auf, die sich im dargestellten Ausführungsbeispiel innerhalb der Leiterplatte 100 befindet. Ebenso gut kann die wenigstens eine Leiterbahn 110 auch auf einer der Oberflächen 102, 104 der Leiterplatte 100 angeordnet sein. Die Leiterplatte 100 weist durch die Leiterplatte 100 durchreichende bzw. durchgreifende Kontaktierungsöffnungen 130 auf. Die Kontaktierungsöffnungen 130 können mit der Leiterbahn 110 elektrisch leitend verbunden sein. Die Kontaktierungsöffnungen 130 können an ihren Innenwandungen 132 eine metallisierte Beschichtung aufweisen, bevorzugt sind die Innenwandungen 132 der Kontaktierungsöffnungen 130 vollständig metallisiert. Die Leiterplatte 100 kann mit auf der Leiterplatte 100 befestigten elektrischen und/oder elektronischen Bauelementen 150 bestückt sein. Bei den elektrischen bzw. elektronischen Bauelementen 150 kann es sich beispielsweise um passive Bauelemente 152, wie zum Beispiel Kondensatoren oder Widerstände handeln oder aber um integrierte Schaltkreise, wie zum Beispiel einen anwenderspezifischen integrierten Schaltkreis (ASIC) 154. Diese Bauelemente 150 können beispielsweise durch einen Lötprozess oder einen Bondprozess auf der Leiterplatte 100 befestigt sein.

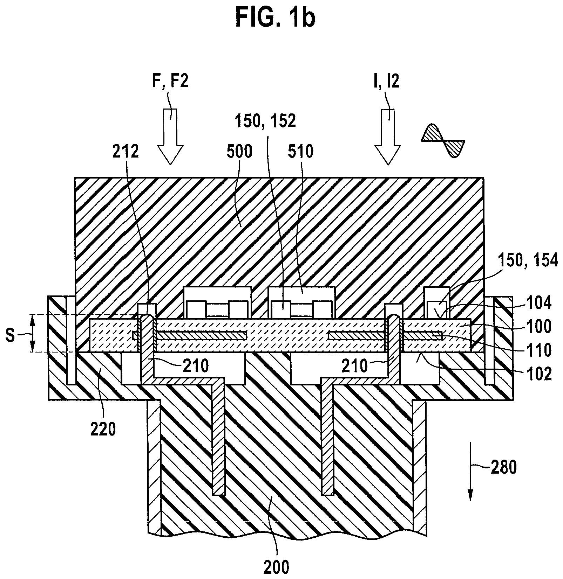

Das Einpress-Bauelement 200 weist der Leiterplatte 100 zugewandte Einpress-Stifte 210 auf, von denen zwei in der dargestellten Querschnittsansicht erkennbar sind. Die Einpress-Stifte 210 weisen der Leiterplatte 100 zugewandte freie Enden 212 auf, die mit den Kontaktierungsöffnungen 130 der Leiterplatte 100 fluchten. Das Einpress-Bauelement 200 ist dabei ortsfest fixiert, wobei die Halterung zur Fixierung des Einpress-Bauelements in der Figur nicht dargestellt ist. Das Einpress-Bauelement 200 ist im dargestellten Ausführungsbeispiel als eine Art Steckergehäuse ausgebildet, in welchem die Einpress-Stifte 210 z.B. kunststoffumspritzt befestigt sind. An der der Leiterplatte 100 zugewandten Seite ist das Einpress-Bauelement 200 becherartig gestaltet, wobei eine beispielsweise umlaufende Außenwand 242 ein Inneres 240 der Becherform begrenzt. Die Einpress-Stifte 210 sind dabei im Innern 240 der Becherform angeordnet. Im Innern 240 der Becherform sind auf einem Boden 244 der Becherform Distanzstücke 220 bzw. Auflageelemente 220 angeordnet, auf denen die Leiterplatte 100 im auf die Einpress-Stifte 210 aufgepressten Zustand zur Anlage kommen kann (Fig. 1b). Die Einpress-Stifte 210 ragen mit ihren freien Enden 212 entlang einer Aufpressrichtung 280 um eine Wegstrecke S über die Auflageelemente 220 hinaus.

Die Sonotrode 500 weist an ihrer der Leiterplatte 100 zugewandten Seite eine Auflagefläche 502 auf, die geeignet ist, direkt auf der zweiten Seite 104 der Leiterplatte 100 aufgesetzt zu werden. An ihrer Außenseite weist die Sonotrode 500 eine kragenförmige Außenwand 520 auf, die beim Aufsetzen der Sonotrode 500 auf die Leiterplatte 100 die Leiterplatte 100 begrenzt. In der der Leiterplatte 100 zugewandten Seite der Sonotrode sind in der Auflagefläche 502 Aussparungen 510 vorgesehen. Die Aussparungen 510 sind an denjenigen Stellen vorgesehen, die beim Aufsetzen der Sonotrode 500 auf die Leiterplatte 100 über denjenigen Stellen der Leiterplatte 100 zu liegen kommen, an denen sich auf der Leiterplatte 100 Bauelemente 150 befinden. Dadurch wird gewährleistet, dass die Sonotrode 500 mit ihrer Auflagenfläche 502 an jeder Stelle unmittelbar mit der zweiten Seite 104 der Leiterplatte in Kontakt kommt, also ohne ein bereits bestücktes Bauelement 150 entlang der Aufpressrichtung 280 zu berühren und ohne es daher direkt mit Ultraschall zu beaufschlagen. An der Sonotrode 500 sind hier nicht dargestellte Mittel vorgesehen, um die Sonotrode 500 während des Einpress-Schritts mit der Leiterplatte 100 zu verbinden. Beispielsweise kann die Sonotrode 500 die Leiterplatte 100 mittels Vakuum an ihrer Auflagefläche 502 ansaugen. Die Sonotrode 500 kann für den Einpress-Schritt auch mit der Leiterplatte 100 verschraubt werden oder durch Magnetkraft mit der Leiterplatte 100 temporär fest verbunden werden.

In Fig. 1a ist der Einpress-Schritt bzw. der Aufpressvorgang zu einem Zeitpunkt dargestellt, zu dem die Leiterplatte 100 mit ihren Kontaktierungsöffnungen 130 auf die freien Enden 212 der Kontaktstifte 210 des Einpress-Bauelements 200 aufgesetzt worden ist und bei dem die Sonotrode 500 noch nicht mit der Leiterplatte 100 in Verbindung gebracht worden ist. Das Verfahren kann in einer hier nicht dargestellten Form auch derart durchgeführt werden, dass zunächst die Leiterplatte 100 an der Sonotrode 500 befestigt wird und anschließend die mit der Sonotrode 500 verbundene Leiterplatte 100 auf die Einpress-Stifte 210 gesetzt wird. Um nun die Leiterplatte 100 auf die Einpress-Stifte 210 zu pressen wird die Sonotrode 500 mit einer ersten Kraft (F1) und einer ersten Ultraschallenergie (I1) in Aufpressrichtung 280 gegen die Einpress-Stifte 210 gepresst. Das Einpress-Bauelement 200 ist dabei ortsfest fixiert.

In Fig. 1b ist die Anordnung aus Fig. 1a im Aufgepressten Zustand der Leiterplatte 100 auf die Einpress-Stifte 210 dargestellt. Dabei ist die Leiterplatte 100 um die Wegstrecke S auf die Einpress-Stifte 210 des Einpress-Bauelements 200 aufgepresst worden. Die Einpress-Stifte 210 durchragen dabei die Leiterplatte 100. Es sei angemerkt, dass in der Sonotrode 500 auch Aussparungen 510 für die die Leiterplatte 100 nun durchragenden freien Enden 212 der Einpress-Stifte 210 vorgesehen sind. Die Leiterplatte 100 liegt im aufgepressten Zustand auf den Auflageelementen 220 auf. In diesem Zustand, das heißt nach dem Aufpressen der Leiterplatte 100 um die Wegstrecke S auf die Einpress-Stifte 210, kann die bis dahin im Wesentlichen formschlüssige bzw. kraftschlüssige Verbindung zwischen den Einpress-Stiften 210 und der Leiterplatte 100 noch durch eine stoffschlüssige Komponente ergänzt werden. Dazu wird die Sonotrode mit einer zweiten Kraft (F2) beaufschlagt. Diese zweite Kraft (F2) kann annähernd oder sogar gleich Null sein. Die Sonotrode wird insbesondere jedoch mit einer zweiten Ultraschallenergie (I2) beaufschlagt, wobei die zweite Ultraschallenergie (I2) größer ist als die erste Ultraschallenergie (I1). Die zweite Ultraschallenergie (I2) kann erheblich größer sein als die erste Ultraschallenergie (I1), z.B. um wenigstens 25% größer, bevorzugt um wenigstens 50% größer. Dazu kann die Amplitude und/oder die Frequenz der Ultraschall-Schwingung erhöht werden. Die infolge der Beaufschlagung mit der zweiten Ultraschallenergie (I2) in Schwingungen versetzte Leiterplatte 100 kann nun mit den Innenwänden 132 ihrer Kontaktierungsöffnung 130 eine Reibverschweißung mit der Oberfläche der Einpress-Stifte 210 eingehen. Eine derartige Verbindung weist eine besonders hohe Haltekraft, eine besonders hohe elektrische Zuverlässigkeit und besonders geringe elektrisch Übergangswiderstände auf. Wie weiter oben beschrieben kann die zweite Ultraschallenergie (I2) jedoch auch gleich der ersten Ultraschallenergie (I1) sein. Die zweite Ultraschallenergie (I2) kann jedoch auch geringer sein als die erste Ultraschallenergie (I1), z.B. um wenigstens 25% geringer. Die zweite Ultraschallenergie (I2) kann sich auch beispielsweise bei gleicher Energie wie die erste Ultraschallenergie (I1) durch Parameter der Ultraschallschwingung von der ersten Ultraschallenergie (I1) unterscheiden, z.B. durch eine andere Frequenz bei gleichzeitig anderer Amplitude.

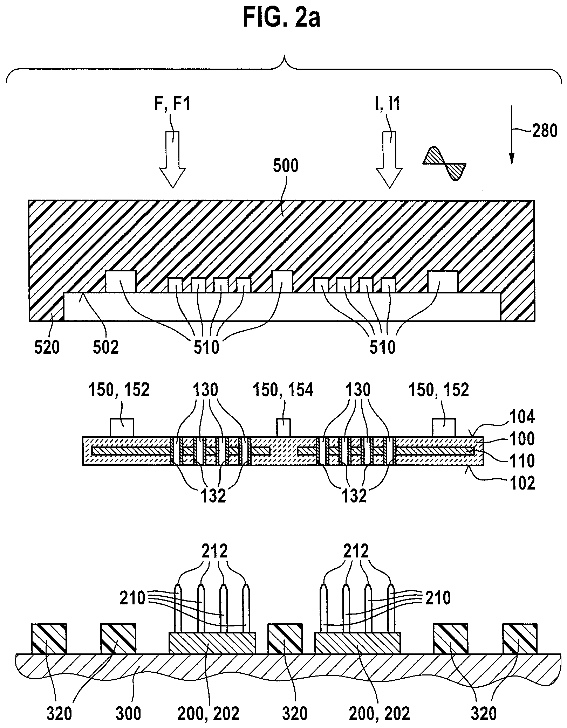

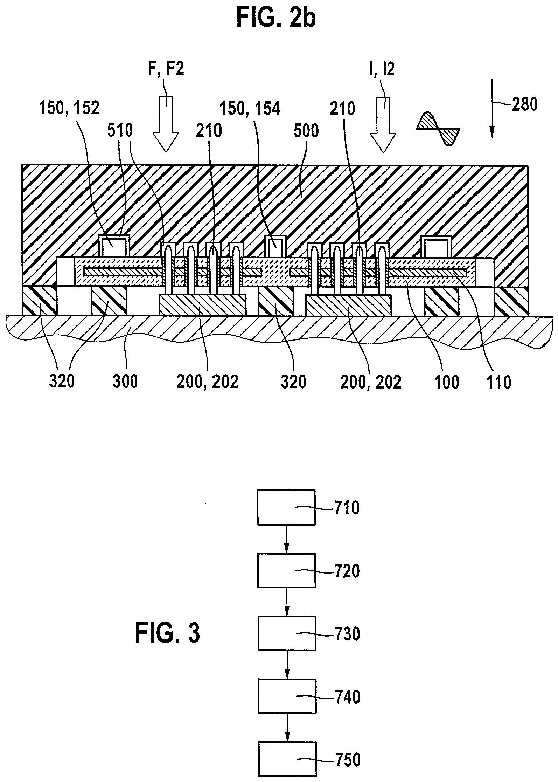

In den Figs. 2a und 2b ist das erfindungsgemäße Verfahren analog zu den Figs. 1a und 1b dargestellt. Im Unterschied zu den Figs. 1a und 1b ist das Einpress-Bauelement 200 hier jedoch nicht als eine Art Steckverbinder bzw. Stecker ausgebildet. Vielmehr sind auf einem Träger 300 mehrere Distanzstücke 320 bzw. Auflageelemente 320 angeordnet. Zwischen den Auflageelementen 320 sind Einpress-Bauelemente 200, beispielsweise Sensoren oder integrierte Schaltkreise, z.B. in Form von SOIC-Gehäusen 202 (SOIC = "Small Outline Integrated Circuit") derart angeordnet, dass die Einpress-Stifte 210 der Einpress-Bauelemente 200 vom Träger 300 weg weisen und der Leiterplatte 100 zugewandt sind. In der Leiterplatte 100 sind entsprechend dem vorherigen Ausführungsbeispiel für jeden Einpress-Stift 210 korrespondierende Kontaktierungsöffnungen 130 angeordnet. In derselben Weise sind in der Sonotrode 500, mit der die Leiterplatte 100 mit Kraft und Ultraschall beaufschlagt werden kann, Aussparungen 510 vorgesehen. Die Aussparungen 510 befinden sich wieder an den Stellen, an denen auf der zweiten Seite 104 der Leiterplatte 100 Bauelemente 150 vorgesehen sind bzw. auch an denjenigen Stellen, in welche die nach dem Einpress-Schritt durch die Kontaktierungsöffnungen 130 der Leiterplatte 100 hindurchragenden freien Enden 212 der Einpress-Stifte 200 zu liegen kommen.

Die Einpress-Bauelemente 200,202 können auf dem Träger 300 beispielsweise durch Vakuum temporär befestigt sein Sie können auch durch eine mechanische, leicht schließ- und öffenbare, Halterung auf dem Träger 300 befestigt sein.

Fig. 2b ist der Zustand dargestellt, in welchem die Leiterplatte mittels der Sonotrode 500 auf die Einpress-Stifte 210 aufgepresst ist. Auch in diesem Ausführungsbeispiel kann durch die Beaufschlagung der Leiterplatte 100 mittels einer zweiten Ultraschallenergie (I2) durch die Sonotrode 500 eine stoffschlüssige Verbindung zwischen den Kontaktierungsöffnungen 130 bzw. der Innenwandung 132 der Kontaktierungsöffnung 130 der Leiterplatte 100 und den Einpress-Stiften 210 bewirkt werden. Wird nun die Sonotrode 500 entfernt und die Halterung der Einpress-Bauelemente 200 vom Träger 300 gelöst, so ist die Leiterplatte 100 fertig mit den Einpress-Bauelementen 200 bestückt und kann vom Träger 300 entnommen werden.

Auf diese Weise können Leiterplatten 100 mittels ultraschallunterstützter Einpresskontaktierung bzw. kalter Kontaktiertechnik in einem einzigen Schritt mit einer Vielzahl von Einpress-Bauelementen 200,202 bestückt werden (inklusive einer stoffschlüssigen Verbindung), ohne dass es zu einer thermischen Belastung der Leiterplatte 100 oder der zu bestückenden Einpress-Bauelemente 200 kommt, wie es beispielsweise beim Reflow-Löten der Fall ist.

In Fig. 3 ist das Verfahren zur lötfreien elektrischen Einpresskontaktierung von elektrisch leitfähigen Einpress-Stiften 210 in Leiterplatten 100 schematisch dargestellt. In einem ersten Schritt 710 wird eine Leiterplatte 100 mit wenigstens einem Wesentlichen senkrecht durch die Leiterplatte 100 hindurchgeführten Kontaktierungsöffnung 130 bereitgestellt, wobei die Kontaktierungsöffnung 130 zur Einpresskontaktierung geeignet ist. In einem zweiten Schritt 720 wird ein Einpress-Bauelement 200,202 mit wenigstens einem elektrisch leitfähigen Einpress-Stift 210 bereitgestellt. In einem dritten Schritt 730 wird eine Sonotrode 500 zur Ausübung einer Kraft und zur Aufbringung von Ultraschallenergie bereitgestellt. Diese drei Schritte 710,720,730 können in veränderter Reihenfolge oder gleichzeitig durchgeführt werden.

Weiterhin ist auf die ersten drei Schritt folgend ein Einpress-Schritt 740 vorgesehen. Dabei ist das wenigstens eine Einpress-Bauelement 200 mit seinem wenigstens einen Einpress-Stift 210 während des Einpress-Schritts 740 fixiert, insbesondere ortsfest gehalten. In dem Einpress-Schritt 740 wird weiterhin die Leiterplatte 100 mittels der Sonotrode 500 derart mit einer Kraft (F), insbesondere einer ersten Kraft (F1) und mit einer Ultraschallenergie (I), insbesondere einer ersten Ultraschallenergie (I1), direkt beaufschlagt, dass die Leiterplatte 100 an der Stelle ihrer wenigstens einen Kontaktierungsöffnung 130 auf den wenigstens einen nicht direkt mittels der Sonotrode 500 beaufschlagten Einpress-Stift 210 des wenigstens einen Einpress-Bauelements 200 aufgepresst wird. Mit anderen Worten wird nur die Leiterplatte 100 direkt mit Ultraschallenergie (I) und Kraft (F) beaufschlagt. In dem Einpress-Schritt 740 kann die Leiterplatte 100 um eine Wegstrecke S auf den wenigstens einen Einpress-Stift 210 aufgepresst werden. Nach Erreichen der Wegstrecke S kann sich ein weiterer Schritt 750 an den Einpress-Schritt 740 anschließen, wobei der weitere Schritt 750 als dem Einpress-Schritt 740 nachgelagerte Teilschritt des Einpress-Schritts 740 betrachtet werden kann. In diesem weiteren Schritt 750 kann die Sonotrode eine zweite Kraft (F2) auf die Leiterplatte 100 ausüben, wobei die zweite Kraft (F2) sehr gering gegenüber der ersten Kraft (F1) sein kann, beispielsweise höchstens 10% der ersten Kraft (F1) beträgt oder sogar Null ist. Weiterhin kann in dem weiteren Schritt 750 die Sonotrode 500 eine zweite Ultraschallenergie (I2) auf die Leiterplatte 100 beaufschlagen, wobei die zweite Ultraschallenergie (I2) größer als die erste Ultraschallenergie (I1) sein kann. Die zweite Ultraschallenergie (I2) kann insbesondere derart groß sein, dass eine stoffschlüssige Reibschweißverbindung zwischen der Leiterplatte und dem wenigstens einen Einpress-Stift 210 erzielt wird. Alternativ kann die zweite Ultraschallenergie (I2) selbstverständlich auch gleich groß sein wie die erste Ultraschallenergie (I1) oder sie kann geringer sein als die erste Ultraschallenergie (I1).

Das erfindungsgemäße Verfahren eignet sich beispielsweise zur Anwendung bei der Herstellung von Produkten, bei denen eine lötfreie elektrische Kontaktierung notwendig ist, um thermische Belastungen beim Herstell-Prozess gering zu halten, beispielsweise bei elektrischen oder elektronischen Steuergeräten für Kraftfahrzeuge, bei der Kontaktierung von Leiterplatten für Computer, Smartphones, Tablet-PCs und anderen Consumer-Elektronik-Geräten oder bei der Herstellung von Netzwerk-Steckern für Hochgeschwindigkeits-Datenübertragungen.

## Patentansprüche

1. Verfahren zur lötfreien elektrischen Einpresskontaktierung von elektrisch leitfähigen Einpress-Stiften (210) in Leiterplatten (100) mit folgenden Schritten:
∘ Bereitstellen einer Leiterplatte (100) mit wenigstens einer im Wesentlichen senkrecht durch die Leiterplatte (100) hindurchgeführten Kontaktierungsöffnung (130) zur Einpresskontaktierung,
∘ Bereitstellen wenigstens eines Einpress-Bauelements (200) mit wenigstens einem elektrisch leitfähigen Einpress-Stift (210),
∘ Bereitstellen einer Sonotrode (500) zur Ausübung einer Kraft und zur Aufbringung von Ultraschallenergie,
**dadurch gekennzeichnet, dass**
das wenigstens eine Einpress-Bauelement (200) mit seinem wenigstens einen Einpress-Stift (210) während eines Einpress-Schritts fixiert ist, insbesondere ortsfest gehalten ist,
und dass in dem Einpress-Schritt die Leiterplatte (100) mittels der Sonotrode (500) derart mit einer Kraft (F) und mit Ultraschallenergie (I) direkt beaufschlagt wird, dass die Leiterplatte (100) an der Stelle ihrer wenigstens einen Kontaktierungsöffnung (130) auf den wenigstens einen nicht direkt mittels der Sonotrode (500) beaufschlagten Einpress-Stift (210) des wenigstens einen Einpress-Bauelements (200) aufgepresst wird.

2. Verfahren nach Anspruch 1, **dadurch gekennzeichnet, dass**
die Leiterplatte (100) vor dem Einpress-Schritt bereits mit Bauelementen (150) bestückt ist, insbesondere, dass das Bestücken der Leiterplatte (100) mit Bauelementen bis auf den Einpress-Schritt für das Bestücken mit dem wenigstens einen Einpress-Bauelement (200) vollständig beendet ist.

3. Verfahren nach Anspruch 2, **dadurch gekennzeichnet, dass**
die Sonotrode (500) auf einer der Leiterplatte (100) zugewandten Seite (502) an denjenigen Stellen Aussparungen aufweist, die beim Einpress-Schritt den mit Bauelementen (150) bestückten Stellen der der Sonotrode (500) zugewandten Seite (104) der Leiterplatte (100) gegenüberliegen.

4. Verfahren nach einem der vorhergehenden Ansprüche, **dadurch gekennzeichnet, dass**
die Leiterplatte (100) eine dem wenigstens einen Einpress-Bauelement (200) zugewandte erste Seite (102) und eine von der ersten Seite abgewandte zweite Seite (104) aufweist,
wobei die Sonotrode (500) beim Einpress-Schritt auf der zweiten Seite (104) aufgesetzt wird,
wobei die Sonotrode (500) insbesondere wenigstens 75% der Fläche der zweiten Seite (104) überdeckt.

5. Verfahren nach einem der vorhergehenden Ansprüche, **dadurch gekennzeichnet, dass**
die Sonotrode (500) die Leiterplatte (100) während des Einpress-Schritts entlang der Erstreckungsrichtung der wenigstens einen Kontaktierungsöffnung (130) über eine Wegstrecke S auf den wenigstens einen Einpress-Stift (210) aufpresst,
wobei die Sonotrode (500) während des Einpress-Schritts entlang der Wegstrecke S mit einer ersten Kraft (F1) und mit einer ersten Ultraschallenergie (I1) beaufschlagt wird.

6. Verfahren nach Anspruch 5, **dadurch gekennzeichnet, dass**
nach Erreichen der Wegstrecke S die Sonotrode (500) eine zweite Kraft (F2) auf die Leiterplatte (100) ausübt,
wobei die zweite Kraft (F2) sehr gering gegenüber der ersten Kraft (F1) ist, insbesondere dass die zweite Kraft (F2) höchstens 10% der ersten Kraft (F1) beträgt,
wobei die Sonotrode (500) nach Erreichen der Wegstrecke S eine zweite Ultraschallenergie (I2) auf die Leiterplatte (100) beaufschlagt,
wobei die zweite Ultraschallenergie (I2) größer ist als die erste Ultraschallenergie (I1), insbesondere um wenigstens 25% größer ist als die erste Ultraschallenergie (I1) oder wobei die zweite Ultraschallenergie (I2) geringer ist als die erste Ultraschallenergie (I1), insbesondere um wenigstens 25% geringer als die erste Ultraschallenergie (I1) oder wobei die zweite Ultraschallenergie (I2) gleich der ersten Ultraschallenergie (I1) ist.

7. Verfahren nach einem der vorhergehenden Ansprüche, **dadurch gekennzeichnet, dass**
der wenigstens eine Einpress-Stift (210) aus einem Material besteht, das Metall oder eine Metall-Legierung aus der Gruppe Aluminium oder Kupfer oder Eisen umfasst.

8. Verfahren nach einem der vorhergehenden Ansprüche, **dadurch gekennzeichnet, dass**
der wenigstens eine Einpress-Stift (210) massiv ausgebildet ist, insbesondere ohne einen Hohlraum und ohne federnde Abschnitte.

9. Verfahren nach einem der vorhergehenden Ansprüche, **dadurch gekennzeichnet, dass**
an dem wenigstens einen Bauelement (200) eine Mehrzahl von Einpress-Stiften (210), insbesondere wenigstens zwei Einpress-Stifte (210) oder wenigstens vier Einpress-Stifte (210), vorgesehen sind,
wobei eine Leiterplatte (100) bereitgestellt wird, die eine Anzahl von Kontaktierungsöffnungen (130) aufweist, die wenigstens der Anzahl der Einpress-Stifte (210) des wenigstens einen Bauelements (200) entspricht.

## Claims

1. Method for solder-free electrical press-in contacting of electrically conductive press-in pins (210) in printed circuit boards (100), comprising the following steps:
° providing a printed circuit board (100) having at least one contact-making opening (130), which is routed substantially vertically through the printed circuit board (100), for press-in contacting,
° providing at least one press-in component (200) having at least one electrically conductive press-in pin (210),
° providing a sonotrode (500) for exerting a force and for applying ultrasonic energy,
**characterized in that**
the at least one press-in component (200) having at least one electrically conductive press-in pin (210) is fixed, in particular is held fixed in position, during a press-in step,
and **in that**, in the press-in step, the printed circuit board (100) is directly subjected to the action of a force (F) and of ultrasonic energy (I) by means of the sonotrode (500) in such a way that the printed circuit board (100), at the point of its at least one contact-making opening (130), is pressed onto the at least one press-in pin (210) of the at least one press-in component (200), which press-in pin is not directly subjected to the action of the sonotrode (500).

2. Method according to Claim 1, **characterized in that** the printed circuit board (100) is already populated with components (150) before the press-in step, in particular **in that** the population of the printed circuit board (100) with components is completely terminated apart from the press-in step for the population with the at least one press-in component (200).

3. Method according to Claim 2, **characterized in that** the sonotrode (500) has cutouts on a side (502) which faces the printed circuit board (100) at those points which, during the press-in step, are situated opposite the points of that side (104) of the printed circuit board (100) which faces the sonotrode (500) which are populated with components (150).

4. Method according to one of the preceding claims, **characterized in that**
the printed circuit board (100) has a first side (102) which faces the at least one press-in component (200) and a second side (104) which is averted from the first side,
wherein the sonotrode (500) is mounted on the second side (104) during the press-in step,
wherein the sonotrode (500) covers, in particular, at least 75% of the surface area of the second side (104).

5. Method according to one of the preceding claims, **characterized in that**
the sonotrode (500) presses the printed circuit board (100) onto the at least one press-in pin (210) over a distance S along the direction of extent of the at least one contact-making opening (130) during the press-in step,
wherein the sonotrode (500) is acted on by a first force (F1) and by a first amount of ultrasonic energy (I1) along the distance S during the press-in step.

6. Method according to Claim 5, **characterized in that** the sonotrode (500) exerts a second force (F2) onto the printed circuit board (100) after the distance S is reached,
wherein the second force (F2) is very small in comparison to the first force (F1),
in particular **in that** the second force (F2) is at most 10% of the first force (F1),
wherein the sonotrode (500) applies a second amount of ultrasonic energy (12) to the printed circuit board (100) after the distance S is reached,
wherein the second amount of ultrasonic energy (12) is greater than the first amount of ultrasonic energy (I1), in particular is greater than the first amount of ultrasonic energy (I1) by at least 25%, or wherein the second amount of ultrasonic energy (12) is smaller than the first amount of ultrasonic energy (I1), in particular is smaller than the first amount of ultrasonic energy (I1) by at least 25%, or wherein the second amount of ultrasonic energy (12) is equal to the first amount of ultrasonic energy (I1).

7. Method according to one of the preceding claims, **characterized in that**
the at least one press-in pin (210) is composed of a material which comprises metal or a metal alloy from amongst the group comprising aluminium and copper and iron.

8. Method according to one of the preceding claims, **characterized in that**
the at least one press-in pin (210) is of solid design, in particular without a cavity and without resilient sections.

9. Method according to one of the preceding claims, **characterized in that**
a plurality of press-in pins (210), in particular at least two press-in pins (210) or at least four press-in pins (210), are provided on the at least one component (200),
wherein a printed circuit board (100) is provided, which has a number of contact-making openings (130) which corresponds at least to the number of press-in pins (210) of the at least one component (200).

## Revendications

1. Procédé de mise en contact électrique par insertion sans soudure de broches électriquement conductrices (210) à insérer dans des cartes de circuits imprimés (100), présentant les étapes suivantes:
o préparer une carte de circuits imprimés (100) avec au moins une ouverture de mise en contact (130) menée essentiellement perpendiculairement à travers la carte de circuits imprimés (100) pour la mise en contact par insertion,
o préparer au moins un composant à insérer (200) avec au moins une broche électriquement conductrice à insérer (210),
o préparer une sonotrode (500) pour exercer une force et pour émettre de l'énergie ultrasonore,
**caractérisé en ce que**
ledit au moins un composant à insérer (200) est fixé avec son au moins une broche à insérer (210) pendant une étape d'insertion, en particulier est maintenu de façon fixe, et **en ce que**
dans l'étape d'insertion, la carte de circuits imprimés (100) est soumise directement au moyen de la sonotrode (500) à une force (F) et à de l'énergie ultrasonore (I), de telle manière que la carte de circuits imprimés (100) soit pressée, à l'endroit de son au moins une ouverture de mise en contact (130), sur ladite au moins une broche à insérer (210) dudit au moins un composant à insérer (200) non exposée directement à la sonotrode (500).

2. Procédé selon la revendication 1, **caractérisé en ce que** la carte de circuits imprimés (100) est déjà garnie de composants (150) avant l'étape d'insertion, en particulier **en ce que** la garniture de la carte de circuits imprimés (100) avec des composants est entièrement terminée avant l'étape d'insertion pour la garniture avec ledit au moins un composant à insérer (200).

3. Procédé selon la revendication 2, **caractérisé en ce que** la sonotrode (500) présente des découpes sur un côté (502) tourné vers la carte de circuits imprimés (100), aux endroits qui lors de l'étape d'insertion font face aux endroits du côté (104) de la carte de circuits imprimés (100) tourné vers la sonotrode (500) garnis de composants (150).

4. Procédé selon l'une quelconque des revendications précédentes, **caractérisé en ce que** la carte de circuits imprimés (100) présente un premier côté (102) tourné vers ledit au moins un composant à insérer (200) et un second côté (104) détourné du premier côté, dans lequel la sonotrode (500) est posée sur le second côté (104) lors de l'étape d'insertion, dans lequel la sonotrode (500) recouvre en particulier au moins 75 % de la surface du second côté (104).

5. Procédé selon l'une quelconque des revendications précédentes, **caractérisé en ce que** la sonotrode (500) presse la carte de circuits imprimés (100) sur ladite au moins une broche à insérer (210), pendant l'étape d'insertion, sur une course S le long de la direction d'extension de ladite au moins une ouverture de mise en contact (130), dans lequel la sonotrode (500) est soumise à une première force (F1) et à une première énergie ultrasonore (I1) pendant l'étape d'insertion le long de la course S.

6. Procédé selon la revendication 5, **caractérisé en ce que**
après accomplissement de la course S, la sonotrode (500) exerce une seconde force (F2) sur la carte de circuits imprimés (100),
dans lequel la seconde force (F2) est très faible par rapport à la première force (F1), en particulier **en ce que** la seconde force (F2) vaut au maximum 10 % de la première force (F1),
dans lequel la sonotrode (500), après l'accomplissement de la course S, soumet la carte de circuits imprimés (100) à une seconde énergie ultrasonore (I2),
dans lequel la seconde énergie ultrasonore (I2) est plus élevée que la première énergie ultrasonore (I1), en particulier est plus élevée d'au moins 25 % que la première énergie ultrasonore (I1) ou dans lequel la seconde énergie ultrasonore (I2) est moins élevée que la première énergie ultrasonore (I1), en particulier est moins élevée d'au moins 25 % que la première énergie ultrasonore (I1) ou dans lequel la seconde énergie ultrasonore (I2) est égale à la première énergie ultrasonore (I1).

7. Procédé selon l'une quelconque des revendications précédentes, **caractérisé en ce que** ladite au moins une broche à insérer (210) se compose d'un matériau, qui comprend un métal ou un alliage métallique du groupe comprenant l'aluminium ou le cuivre ou le fer.

8. Procédé selon l'une quelconque des revendications précédentes, **caractérisé en ce que** ladite au moins une broche à insérer (210) est massive, en particulier sans cavité et sans parties élastiques.

9. Procédé selon l'une quelconque des revendications précédentes, **caractérisé en ce qu'**il est prévu sur ledit au moins un composant (200) une multiplicité de broches à insérer (210), en particulier au moins deux broches à insérer (210) ou au moins quatre broches à insérer (210), dans lequel on prépare une carte de circuits imprimés (100), qui présente un nombre d'ouvertures de mise en contact (130), qui correspond au moins au nombre des broches à insérer (210) dudit au moins un composant (200) .
